# EUROPÄISCHE PATENTANMELDUNG

(11) **EP 1 837 893 A1**
(43) Veröffentlichungstag der Anmeldung: **26.09.2007**
(21) Anmeldenummer: 06006200.7
(22) Anmeldetag: 25.03.2006
(51) Int. Cl.: H01J 37/32

(54) **Messeeinrichtung eines HF-Plasmasystems**

(71) Anmelder: HÜTTINGER Elektronik GmbH + Co. KG, 79111 Freiburg (DE)
(72) Erfinder: Gerhardt, Christoph, 79106 Freiburg (DE); Krausse, Daniel, 79106 Freiburg (DE); Riessle, Peter, 79274 St. Märgen (DE)
(74) Vertreter: Kohler Schmid Möbus

(57) **Zusammenfassung**

Bei einer Messeinrichtung (7) eines HF-Plasmasystems mit einer Auskoppeleinrichtung (8) zur Auskopplung eines oder mehrerer mit einer Leistung in Beziehung stehenden Signale und wenigstens einer Filteranordnung, der ein solches Signal zugeführt ist, ist die Filteranordnung als Bandpassfilteranordnung (14,15) ausgebildet und umfasst ein erstes und ein zweites Filterelement (22, 32, 25, 35), zwischen denen ein Entkoppelglied (24, 34) angeordnet ist. Dadurch können die Vorwärtsleistung und eine reflektierter Leistung mit sehr hoher Genauigkeit bestimmt werden.

## Beschreibung

Die Erfindung betrifft eine Messeinrichtung eines HF-Plasmasystems mit einer Auskoppeleinrichtung zur Auskopplung eines oder mehrerer mit einem HF-Signal in Beziehung stehenden Signale und wenigstens einer Filteranordnung, der ein solches Signal zugeführt ist.

HF-Plasmaprozessanregungsanordnungen weisen einen HF-Generator auf, der HF-Leistung an einen Plasmaprozess liefert. Die HF-Leistung wird in der Regel in einem schmalbandigen Frequenzbereich, insbesondere um die Industriefrequenzen 13,56 MHz und 27,12 MHz, an den Plasmaprozess geliefert. Zur Messung der in den Plasmaprozess gelieferten Leistung können Messeinrichtungen vorgesehen sein. Für eine genaue Regelung und/oder Steuerung der Leistung ist es notwendig, die gelieferte Leistung, den Strom, die Spannung, die Impedanz oder auch die Phase zwischen Strom und Spannung genau zu erfassen.

Es gibt unterschiedliche Möglichkeiten, die in die Last gelieferte Leistung eines HF-Plasmaprozessanregungssystems zu bestimmen. Eine häufig verwendete ist die Messung mittels eines Richtkopplers. Ein Richtkoppler koppelt mit der Leistung (in Richtung Last gelieferte Vorwärtsleistung Pᵢ und reflektierte Leistung Pᵣ) in Beziehung stehende Signale aus. Es ist auch bekannt, Spannung und Strom oder die Impedanz und den Phasenwinkel zwischen Spannung und Strom zu messen.

Die ausgekoppelten Signale werden häufig zunächst jeweils in ein Spannungssignal gewandelt, das in einem eindeutigen Zusammenhang zum ausgekoppelten Signal steht, z.B. der Wurzel der Leistung proportional ist. Anschließend sollte das Spannungssignal gefiltert werden. Bekannt sind Tiefpassfilter, bestehend aus Induktivitäten und Kapazitäten einfacher oder höherer Ordnung. Sie dienen zur Filterung der hochfrequenten Anteile, die zumeist als Störungen oder Oberwellen in der Durchführungsleitung auftreten und nicht gemessen werden sollen. Eine Tiefpassfilteranordnung ist auf Grund des Abtasttheorems immer auch dann notwendig, wenn das gemessene Signal digitalisiert werden soll, z.B. mit einem A-D-Wandler. In Plasmasystemen treten aber auch niederfrequente Störungen auf, die ebenfalls zu Messwertfehlern führen können.

Aufgabe der vorliegenden Erfindung ist es, eine Messeinrichtung eines HF-Plasmasystems bereit zu stellen, mit der HF-Signale, bzw. damit zusammenhängende physikalische Größen, genauer bestimmt werden können.

Diese Aufgabe wird erfindungsgemäß durch eine Messeinrichtung der eingangs genannten Art dadurch gelöst, dass die Filteranordnung als Bandpassfilteranordnung ausgebildet ist und ein erstes und ein zweites Filterelement umfasst, zwischen denen ein Entkoppelglied angeordnet ist. Ein Bandpassfilter hat den Vorteil, dass sowohl niederfrequente als auch hochfrequente Störungen, die zu Messwertfehlern führen können, eliminiert werden können. Ein Bandpassfilter herkömmlicher Art würde jedoch eine hohe Restwelligkeit im Durchlassbereich aufweisen. Diese würde wiederum zu von der Frequenz abhängigen Messabweichungen führen. Deshalb ist erfindungsgemäß ein Entkoppelglied zwischen den Filterelementen vorgesehen und ist der Bandpassfilter aus mehreren Filterelementen, vorzugsweise aus einer Hintereinanderschaltung mehrerer Filterelemente, aufgebaut. Dadurch lassen sich die Eigenschaften des ersten Filterelements unabhängig von den Eigenschaften des zweiten Filterelements und umgekehrt einstellen. Somit lässt sich ein extrem flacher Durchlassbereich geringer Dämpfung erreichen. Dies bedeutet, dass über einen großen Frequenzbereich die Dämpfung konstant ist, wobei keine oder nur eine geringe Welligkeit auftritt. Das HF-Signal kann ein mit einer HF-Leistung in Beziehung stehendes Signal sein, beispielsweise ein HF-Strom oder eine HF-Spannung.

Bei einer vorteilhaften Ausführungsform kann das erste Filterelement als Tiefpassfilter und das zweite Filterelement als Hochpassfilter ausgebildet sein. Durch das Tiefpassfilter können die hochfrequenten Teile des das HF-Signal beschreibenden Signals gefiltert werden. Damit kann verhindert werden, dass hochfrequente Anteile auf das Entkoppelglied gelangen. Das Entkoppelglied muss dann nicht für hohe Frequenzen ausgelegt werden, was die Bandpassfilteranordnung kostengünstig und unkritisch in Bezug auf Schwingneigungen macht. Durch das dem Entkoppelglied nachgeordnete Hochpassfilter können die verbleibenden niederfrequenten Störungen ausgefiltert werden. Vorzugsweise handelt es sich bei den Filterelementen um passive Filter. Vorzugsweise werden passive Filter mit Tschebyscheff-Charakteristik höherer Ordnung eingesetzt, um genügend steile Flanken zu erzielen, um harmonische Oberwellen ausreichend bedämpfen zu können, und gleichzeitig für eine vorgegebene Bandbreite abhängig von Frequenzvariabilität und Pulsfrequenz einen Durchlassbereich sicher stellen zu können.

Vorteilhafterweise kann vorgesehen sein, dass die Grenzfrequenzen der Bandpassfilteranordnung einstellbar sind. Dadurch lässt sich die Bandpassfilteranordnung für unterschiedliche Anforderungen auslegen. Durch entsprechende Wahl der Grenzfrequenzen ist die Bandpassfilteranordnung zur Messung der Leistung eines HF-Generators mit fester Frequenz, beispielsweise 13,56 MHz, oder mit entsprechend anderen gewählten Grenzfrequenzen für einen HF-Generator mit Frequenzvariabilität oder für einen HF-Generator, der gepulst betrieben wird, geeignet. Vorzugsweise lassen sich die Grenzfrequenzen für den ersten und den zweiten Filter unabhängig voneinander einstellen, ohne dass der Dämpfungsverlauf verändert wird.

Eine Feinabstimmung bei Inbetriebnahme der Leistungsmesseinrichtung kann erfolgen, wenn die Filterelemente abstimmbar sind. Dabei können die Filterelemente unabhängig voneinander abstimmbar sein.

Besonders bevorzugt ist es, wenn vor dem ersten Filterelement oder vor der Bandpassfilteranordnung ein Dämpfungsglied angeordnet ist. Durch das Dämpfungsglied wird die Anpassung breitbandig verbessert. Mit der breitbandigen Verbesserung ist gemeint, dass die Anpassung auch für Frequenzanteile verbessert wird, die nicht gemessen werden sollen. Dies kann wünschenswert sein, da die unerwünschten Frequenzanteile bei schlechter Anpassung ebenfalls zu Reflexionen und damit zu Messergebnisfehlern führen können. Das erste Filterelement ist z.B. als ein Tiefpassfilter ausgelegt. Es blockiert demnach alle höherfrequenten Signale. Da es diese aber nicht absorbiert, reflektiert es diese zurück zum Dämpfungsglied. Je höher hier ein Dämpfungsfaktor des Dämpfungsglieds ist, umso weniger dieser reflektierten Signale gelangen zurück auf das Auskoppelglied. Je weniger Signale an das Auskoppelglied zurück reflektiert werden, desto geringer sind die Messwertabweichungen. Ein hoher Dämpfungsfaktor an dieser Stelle ist also vorteilhaft. Die Dämpfung verbessert auch die Konstanz im Durchlassbereich, das heißt die Welligkeit im Durchlassbereich wird geringer. Im Bereich von 11,8 MHz bis 15,3 MHz kann mit einem 10dB Dämpfungsglied eine Restwelligkeit von typischerweise 0,064dB, mindestens 0,008dB und maximal 0,108dB erreicht werden.

Es ist sinnvoll, das Dämpfungsglied auf einen Systemwiderstand auszulegen. Der Systemwiderstand kann beliebig gewählt werden. Zwischen Auskoppelglied und Dämpfungsglied kann z.B. eine Leitung angeordnet sein. Da hier Hochfrequenzsignale übertragen werden, muss für diese Leitung ein Wellenwiderstand berücksichtigt werden. Es ist dann sinnvoll den Systemwiderstand des Dämpfungsglieds gleich dem Wellenwiderstand der Leitung zu wählen. So werden Reflexionen wegen Fehlanpassung weitestgehend ausgeschlossen. Ein bei Leitungen, Anschlüssen und Messmitteln in der HF-Technik sehr verbreiteter Widerstandswert für Wellen- und Systemwiderstände ist 50 Ohm, er wird deswegen vorteilhafterweise verwendet. Das Dämpfungsglied kann jede beliebige Form aufweisen, beispielsweise eine n- oder T-Anordnung von Widerständen. Das Dämpfungsglied kann aber auch eine Widerstandstransformation aufweisen, falls dies für das erste Filterelement oder die Bandpassfilteranordnung erforderlich oder wünschenswert ist. Das erste Filterelement weist selbst auch einen Systemwiderstand auf. Dieser kann sich vom Systemwiderstand des Dämpfungsglieds unterscheiden, wenn das gewünscht ist. Dann kann das Dämpfungsglied vorzugsweise so ausgelegt werden, dass es eine Widerstandstransformation vom Systemwiderstand des Dämpfungsglieds zum Systemwiderstand des Filterelements aufweist.

Besonders vorteilhaft ist es, wenn das Entkoppelglied einen Verstärker aufweist. Dadurch kann die durch das erste Filterelement bewirkte Dämpfung im Durchlassbereich wieder ausgeglichen werden. Der Verstärkungsfaktor ist vorzugsweise beliebig einstellbar. Um einen ausreichend großen Rauschabstand sicherzustellen, wird das Dämpfungsglied vorzugsweise so ausgebildet, dass die Signalpegel nach dem Dämpfungsglied nicht allzu klein ausfallen. Demnach kann auch die Verstärkung des Entkoppelglieds relativ gering eingestellt werden, z.B. zwischen 0 und 6dB.

Bei einer Ausgestaltung der Erfindung kann am Ausgang des ersten und/oder zweiten Filterelements ein Abschlusswiderstand vorgesehen sein, dessen Widerstandswert dem Systemwiderstand des jeweiligen Filterelements entspricht. Dieser Abschlusswiderstand sollte möglichst breitbandig sein, also nicht nur im Messbereich wirkungsvoll sein, sondern vor allem auch in den Frequenzbereichen, in denen die Filterelemente eine Dämpfung bewirken. Das erhöht zusätzlich die Anpassung und vermindert Störungen auf Grund von Reflexionen.

Am Ausgang des Entkoppelglieds kann vorzugsweise ein Widerstand in Reihe geschaltet sein, der dem Systemwiderstand des zweiten Filterelements entspricht. Auch dieser Widerstand sollte möglichst breitbandig sein, d.h. über einen bestimmten Frequenzbereich, der vorzugsweise größer ist als der Durchlassbereich der Bandpassfilteranordnung, konstant sein, um Störungen auf Grund von Reflexionen zu unterdrücken.

Bei einer besonders bevorzugten Ausführungsform kann vorgesehen sein, dass dem zweiten Filterelement ein zweites Entkoppelglied nachgeordnet ist. Dann wird das Filterelement nicht durch die folgende Beschaltung belastet und in seinen Eigenschaften verändert. Der Ausgang des zweiten Entkoppelglieds ist vorzugsweise das bandpassgefilterte Signal.

Bei einer Ausführungsform kann ein Detektorglied vorgesehen sein, das der Bandpassfilteranordnung nachgeschaltet ist, und aus dem gefilterten Signal ein DC-Signal generiert, das in einem eindeutigen Bezug zu dem ausgekoppelten Signal steht, z.B. zu der ausgekoppelten Vorwärtsleistung, der reflektierten Leistung oder der Spannung, dem Strom, der Impedanz oder des Phasenwinkels zwischen Spannung und Strom.

Weitere Vorteile ergeben sich, wenn für ein die Vorwärtsleistung Pᵢ und für ein die reflektierte Leistung Pᵣ beschreibendes Signal jeweils eine Bandpassfilteranordnung, besonders bevorzugt jeweils eine Bandpassfilteranordnung mit jeweils einem vorgeschalteten Dämpfungsglied, besonders bevorzugt mit jeweils einem nachgeschalteten Detektorglied, vorgesehen ist. Dadurch können für beide Leistungen bandpassgefilterte Signale erzeugt werden und kann die in die Last gelieferte Leistung P_{L} sehr genau bestimmt werden.

Bei einer Ausführungsform kann ein Differenzbilder vorgesehen sein, der die Differenz aus Pᵢ und Pᵣ ermittelt. Der Differenzbilder ist vorzugsweise den Detektorgliedern nachgeschaltet.

Besonders einfach und kostengünstig lässt sich Pᵢ und/oder Pᵣ auskoppeln, wenn die Auskoppeleinrichtung als Richtkoppler ausgebildet ist. Der Richtkoppler weist eine Durchführungsleitung auf, in der der Strom der zu ermittelnde Leistung fließt. Der Richtkoppler weist weiterhin mindestens eine Koppelleitung auf zur Auskopplung der Vorwärtsleistung und reflektierten Leistung. Es kann aber vorteilhafterweise auch je eine Koppelleitung zur Auskopplung der Vorwärtsleistung und zur Auskopplung der reflektierten Leistung vorgesehen sein. Der Wellenwiderstand der Koppelleitungen ist vorteilhafterweise für den Wellenwiderstand der daran angeschlossenen Leitungen ausgelegt. Durch die Abstimmung auf den Wellenwiderstand können Reflexion vermindert werden und erfolgt eine besonders gute Anpassung.

Die Verwendung von zwei Koppelleitungen ermöglicht es, Pᵢ und Pᵣ getrennt voneinander auszukoppeln. Außerdem können Pᵢ und Pᵣ mit unterschiedlichen Koppelfaktoren ausgekoppelt werden.

Eine Weiterbildung zeichnet sich dadurch aus, dass die Koppelleitungen zumindest an einem Ende mit einem Abschlusswiderstand abgeschlossen sind, dessen Widerstandswert dem Wellenwiderstand der Koppelleitung entspricht. Der Abschlusswiderstand verhindert Reflexionen und gewährleistet dadurch genaue Messergebnisse. Vorzugsweise ist an einem Ende der Koppelleitungen jeweils ausschließlich der Abschlusswiderstand vorgesehen.

Wenn die Abschlusswiderstände abstimmbar sind, kann eine Feinabstimmung erfolgen.

In den Rahmen der Erfindung fällt außerdem ein HF-Plasmasystem mit einem HF-Generator, der eine HF-Leistung an eine Plasmalast liefert, und einer vorher beschriebenen Leistungsmesseinrichtung.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Figuren der Zeichnung näher erläutert. Es zeigt:
- **Fig. 1**: eine schematische Darstellung eines HF-Plasmasystems;
- **Fig. 2**: eine Darstellung einer Messeinrichtung;
- **Fig. 3**: eine Detaildarstellung der Bandpassfilteranordnungen der Messeinrichtung;
- **Fig. 4**: einen Dämpfungsverlauf für eine Bandpassfilteranordnung mit Dämpfungsglied;
- **Fig. 5**: einen Dämpfungsverlauf für eine Bandpassfilteranordnung ohne Dämpfungsglied;
- **Fig. 6**: einen Verlauf des Reflexionsfaktors und des Stehwellenverhältnis einer Bandpassfilteranordnung mit vorgeschaltetem Dämpfungsglied;
- **Fig. 7**: einen Verlauf des Reflexionsfaktors und des Stehwellenverhältnis einer Bandpassfilteranordnung ohne vorgeschaltetes Dämpfungsglied;
- **Fig. 8**: ein Dämpfungsglied in n- Schaltung;
- **Fig. 9**: ein Dämpfungsglied in T-Schaltung;
- **Fig. 10**: ein Filterelement mit Tiefpasseigenschaften;
- **Fig. 11**: ein Filterelement mit Hochpasseigenschaften.

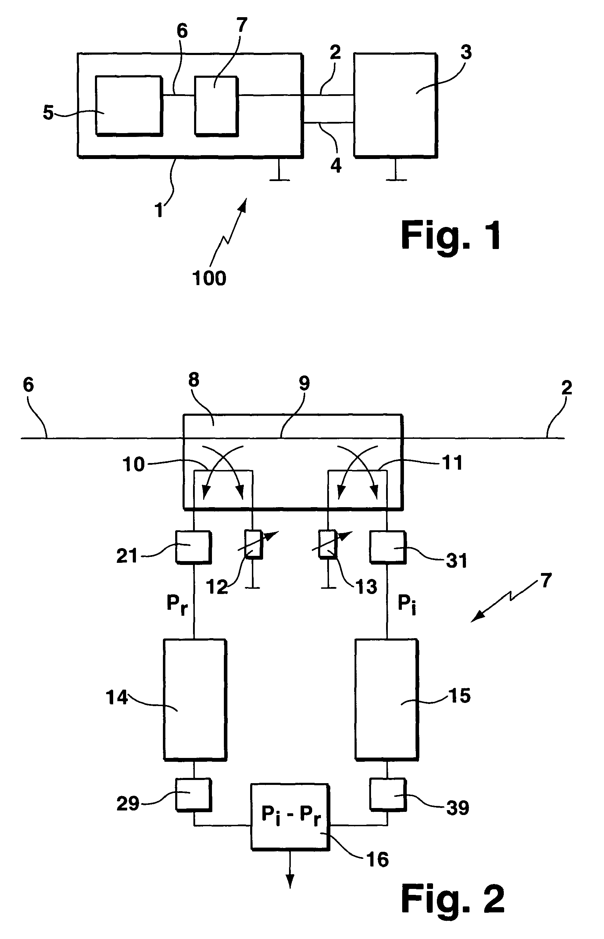

In der Figur 1 ist eine HF-Plasmaprozessanregungsanordnung 1 eines HF-Plasmasystems 100 gezeigt, die über eine Leitung 2 an eine Last 3 angeschlossen ist. Die Leitung 4 stellt eine Masseverbindung dar. Über die Leitung 2 wird HF-Leistung an die Last 3 übertragen. Die HF-Plasmaprozessanregungsanordnung 1 umfasst einen HF-Generator 5, der über eine Leitung 6 mit einer Messeinrichtung 7 verbunden ist. Die Messeinrichtung 7 kann eine Leistungsmesseinrichtung sein, die somit zwischen den HF-Generator 5 und die Last 3 geschaltet ist. Zwischen HF-Plasmaprozessanregungsanordnung 1 und Last 3 kann eine nicht gezeigte Impedanzanpassung angeordnet sein.

Die Messeinrichtung 7 kann auch außerhalb der HF-Plasmaprozessanregungsanordnung 1 angeordnet sein, es ist aber vorteilhaft, sie wie in Fig. 1 gezeigt, innerhalb der HF-Plasmaprozessanregungsanordnung 1 anzuordnen, weil sie dann zur Regelung des HF-Generators 5 unmittelbar eingesetzt werden kann.

In der Figur 2 ist die Messeinrichtung 7 dargestellt, die eine Leistungsmesseinrichtung darstellt. Sie umfasst eine Auskoppeleinrichtung 8, die im Ausführungsbeispiel als Richtkoppler ausgebildet ist. Die Auskoppeleinrichtung 8 weist eine Durchgangsleitung 9 auf, die sowohl mit der Leitung 6 als auch mit der Leitung 2 verbunden ist. Parallel zu der Durchgangsleitung 9 sind eine erste Koppelleitung 10 und eine zweite Koppelleitung 11 vorgesehen. Die Koppelleitung 10 dient dazu, die reflektierte Leistung Pᵣ beziehungsweise ein damit in Beziehung stehendes Signal, auszukoppeln. Die Koppelleitung 11 dient dazu, die vom HF-Generator kommende Vorwärtsleistung Pᵢ, beziehungsweise ein damit in Beziehung stehendes Signal, auszukoppeln. Die Koppelleitungen 10, 11 weisen an einem Ende jeweils einen Abschlusswiderstand 12, 13 auf, wobei die Abschlusswiderstände 12, 13 abstimmbar ausgebildet sind, so dass ein Widerstandswert eingestellt werden kann, der dem Wellenwiderstand der Auskoppeleinrichtung 8 entspricht. Beide Koppelleitungen 10, 11 sind mit einer Bandpassfilteranordnung 14, 15 verbunden, in der die die Vorwärtsleistung Pₗ und die reflektierte Leistung Pᵣ beschreibende Signale gefiltert werden. Den Bandpassfilteranordnungen 14 und 15 sind jeweils Dämpfungsglieder 21 und 31 vorgeschaltet und jeweils Detektorglieder 39 und 29 nachgeschaltet. Die in den Bandpassfilteranordnungen 14, 15 ermittelten Leistungswerte werden auf einen Differenzbilder 16 gegeben, wo die Differenz zwischen Pᵢ und Pᵣ ermittelt wird. Die Differenz stellt die in die Last 3 gelieferte Leistung P_{L} dar. Dieser Leistungswert kann verwendet werden, um den HF-Generator 5 zu steuern und/oder zu regeln.

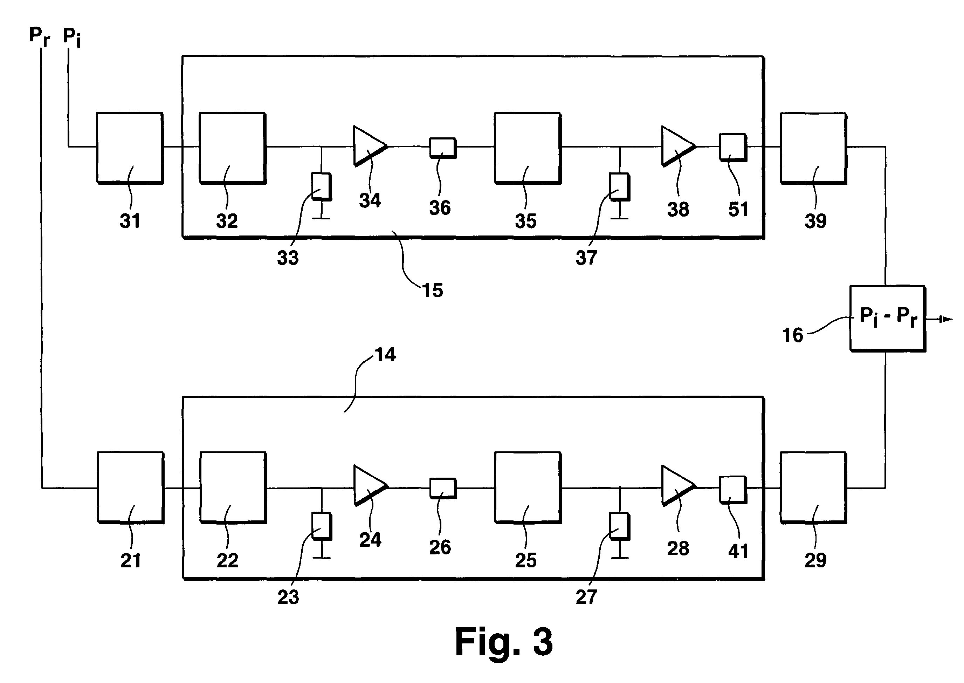

In der Figur 3 sind die Bandpassfilteranordnungen 14, 15 im Detail dargestellt, wobei diese analog zueinander aufgebaut sind. Die von der Auskoppeleinrichtung 8 kommenden Signale gelangen zunächst an ein Dämpfungsglied 21, 31, von wo sie auf erste Filterelemente 22, 32 der Bandpassfilteranordnungen 14, 15 geführt werden. Die Dämpfungsglieder 21, 31 weisen vorzugsweise einen Eingangswiderstand auf, der vorteilhafterweise gleich dem Wellenwiderstand der Verbindungsleitung zwischen den Dämpfungsgliedern 21, 31 und den Koppelleitungen 10 und 11 des Auskoppelglieds 8 sind. Da diese Leitungen und alle Anschlüsse in der HF Technik üblicherweise in 50 Ohm Technik ausgeführt sind, ist auch der Eingangswiderstand der Dämpfungsglieder 21, 31 vorzugsweise gleich 50 Ohm.

Das erste Filterelement 22, 32 weist einen Systemwiderstand auf. Der Ausgang der Dämpfungsglieder 21, 31 ist auf diesen Systemwiderstand ausgelegt, ggf. führt das Dämpfungsglied 21, 31 eine Widerstandstransformation durch. Das erste Filterelement 22, 32 ist vorzugsweise als Tiefpassfilter ausgebildet, und ist seinerseits mit einem Abschlusswiderstand 23, 33 abgeschlossen, dessen Widerstandswert vorzugsweise auch dem Systemwiderstand des ersten Filterelements 22, 32 entspricht. Den ersten Filterelementen 22, 32 ist ein als Verstärker ausgebildetes erstes Entkoppelglied 24, 34 nachgeordnet. Der Verstärkungsfaktor der Entkoppelglieder 24, 34 kann einstellbar sein. Daran schließt sich ein Widerstand 26, 36 an, der auf den Systemwiderstand von zweiten sich daran anschließenden, als Hochpassfilter ausgebildeten Filterelementen 25, 35 abgestimmt ist. Die zweiten Filterelemente 25, 35 weisen einen Abschlusswiderstand 27, 37 auf. Die Widerstände 26, 27, 36, 37 entsprechen vorzugsweise dem Systemwiderstand des zweiten Filterelements 25, 35. Den zweiten Filterelementen 25, 35 nachgeschaltet sind zweite Entkoppelglieder 28, 38, die ebenfalls als Verstärker ausgebildet sein können. Die Verwendung eines zweiten Entkoppelglieds 28, 38 hat den Vorteil, dass die zweiten Filterelemente 25, 35 durch sich an die Bandpassfilteranordnungen 14, 15 anschließende Beschaltungen nicht beeinflusst werden. An den Ausgängen der zweiten Entkoppelglieder 28, 38 liegen die bandpassgefilterten Signale, die die Vorwärtsleistung und reflektierte Leistung beschreiben. Den zweiten Entkoppelgliedern 28, 38 nachgeschaltet sind Widerstände 41 und 51, die dem Systemwiderstand der nachfolgenden Schaltung entsprechen. Die Bandpassfilteranordnungen 14, 15 umfassen demnach die Filterelemente 22, 32, 25, 35, die Widerstände 23, 33, 26, 36, 27, 37 , 41 und 51 und die Entkoppelglieder 24, 34, 28, 38. Den Bandpassfilteranordnungen 14, 15 nachgeschaltet sind Detektoren 29, 39, in denen der entsprechende Leistungswert entweder direkt oder durch Umrechnung ermittelt werden kann. In dem Differenzbilder 16 kann die Differenz der Leistungswerte ermittelt werden.

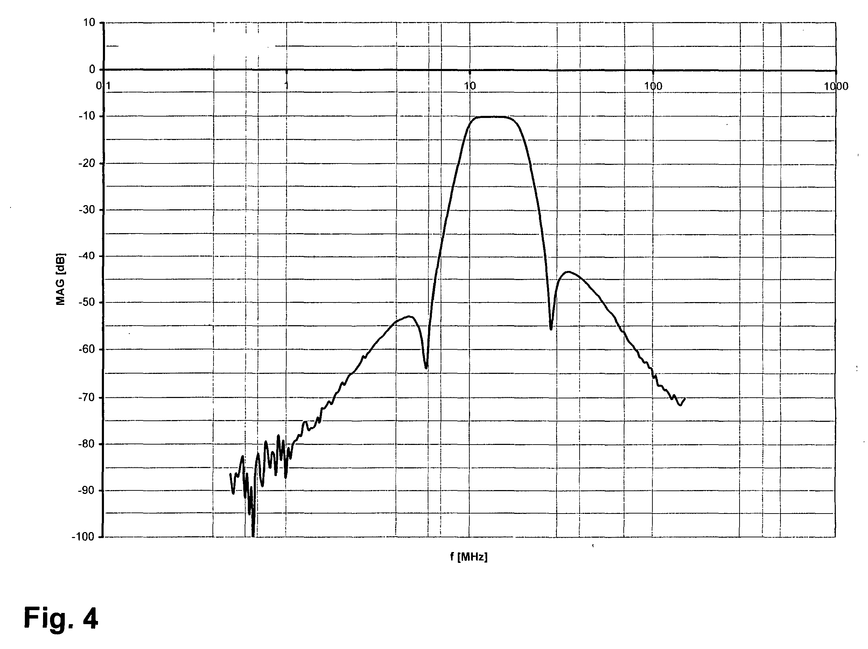

Die Figur 4 zeigt beispielhaft den Dämpfungsverlauf der Spannungsübertragungsfunktion einer Bandpassfilteranordnung 14, 15 mit einem vorgeschalteten Dämpfungsglied 21, 31 in Abhängigkeit von der Frequenz. Zwischen etwa 10 und 15 MHz liegt der Durchiassbereich, wobei in diesem Durchlassbereich die Kurve sehr flach ist und kaum Welligkeit aufweist, die Dämpfung in diesem Bereich also im Wesentlichen konstant ist. Die Dämpfung liegt in diesem Bereich bei etwa -6dB. Außerhalb dieses Bereichs weist der Dämpfungsverlauf steil abfallende Flanken mit einer Dämpfung von über 40dB für Frequenzen größer 20 MHz und kleiner 6 MHz auf. Dank des Dämpfungsglieds 21, 31 kommt es zu keiner Verschlechterung der Dämpfung bei höheren Frequenzen.

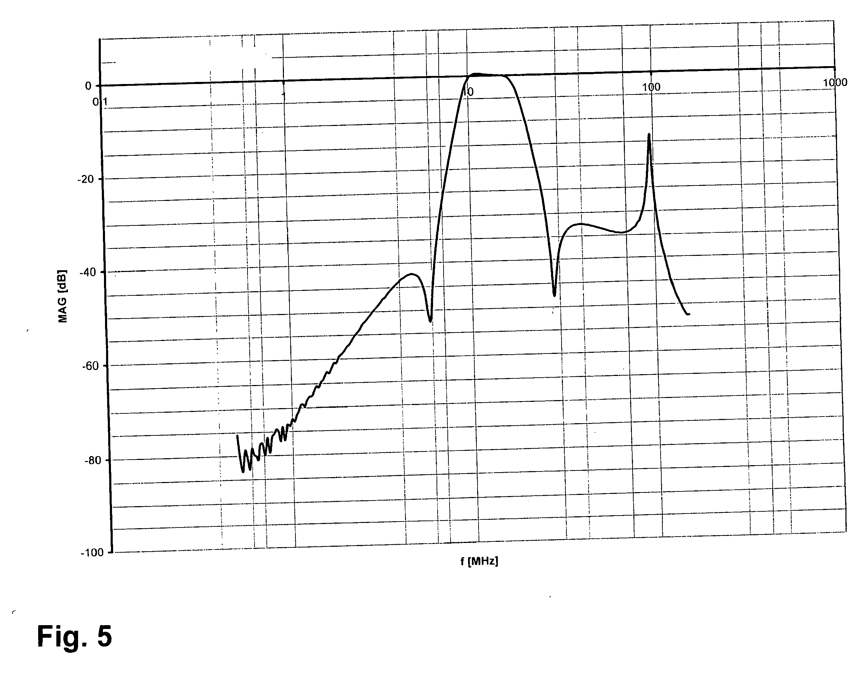

Im Vergleich dazu ist in der Figur 5 ein Dämpfungsverlauf der Spannungsübertragungsfunktion einer Bandpassfilteranordnung 14, 15 ohne ein vorgeschaltetes Dämpfungsglied 21, 31 in Abhängigkeit von der Frequenz gezeigt. Deutlich ist hier die ungenügende Dämpfung bei Frequenzen oberhalb 100MHz zu erkennen. Außerdem ist die deutlich reduzierte Konstanz im Durchlassbereich zu erkennen. Die Dämpfung macht den Bandpassfilter im Durchlassbereich konstant.

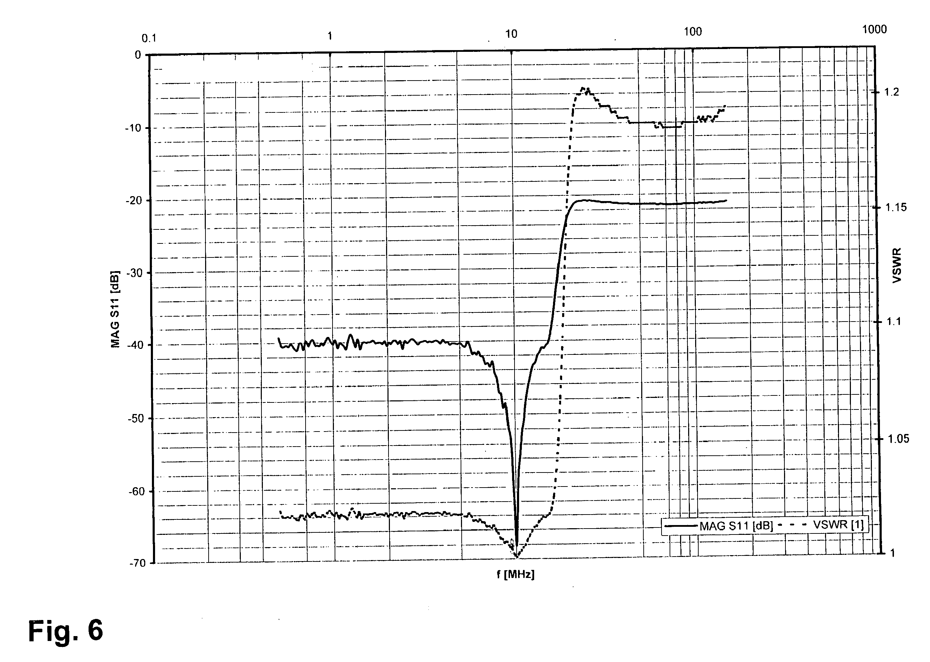

In der Figur 6 sind der Verlauf des Stehwellenverhältnisses (gestrichelte Linie) und des Reflexionsfaktors (durchgezogene Linie) einer Bandpassfilteranordnung 14, 15 mit einem vorgeschalteten Dämpfungsglied 21, 31 in Abhängigkeit von der Frequenz gezeigt.

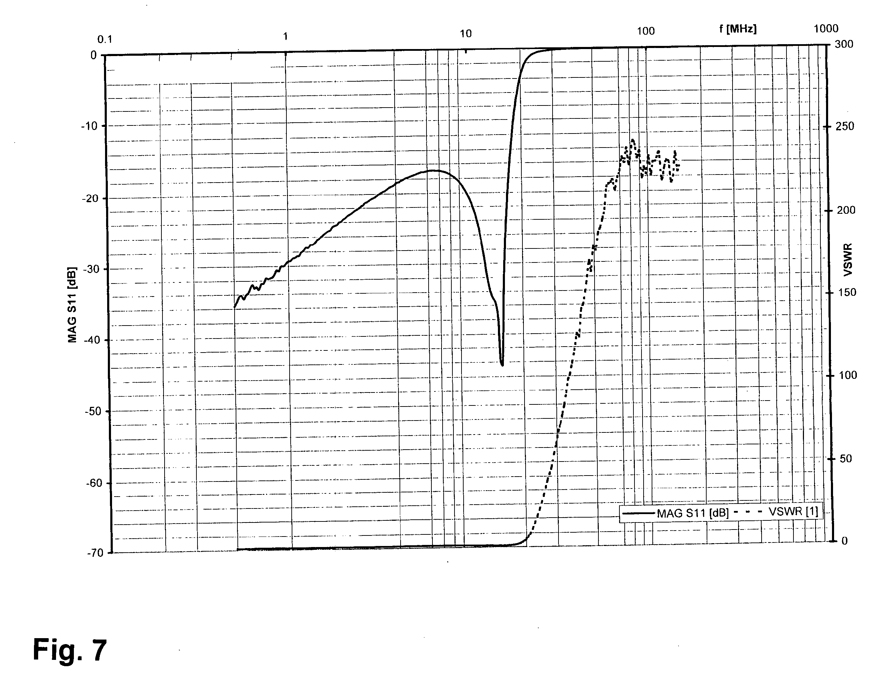

Die Figur 7 zeigt den Verlauf des Stehwellenverhältnisses (gestrichelte Linie) und des Reflexionsfaktors (durchgezogene Linie) derselben Bandpassfilteranordnung 14, 15 ohne ein vorgeschaltetes Dämpfungsglied 21, 31. Die gestrichelte Linie zeigt das Stehwellenverhältnis (voltage standing wave ratio VSWR). Es sollte für eine möglichst gute Eingangsanpassung nahe 1 sein. Zu beachten ist der Anstieg oberhalb 15 MHz in Figur 6 mit einem vorgeschalteten Dämpfungsglied auf Werte von ca. 1.2, wohingegen in Figur 7 Werte von über 200 erreicht werden. Die durchgezogene Linie zeigt den Verlauf des Reflexionsfaktors MAG S11 [dB]. Er sollte möglichst gering sein, vorteilhafterweise kleiner 20dB. Dies wird, wie in der Figur 6 zu sehen ist, mit einem vorgeschalteten Dämpfungsglied bis über 100MHz sicher erreicht, wohingegen ohne ein vorgeschaltetes Dämpfungsglied (Figur 7) ein Reflexionsfaktor nahe 0dB für nahezu vollständige Reflexionen oberhalb 20MHz sorgt.

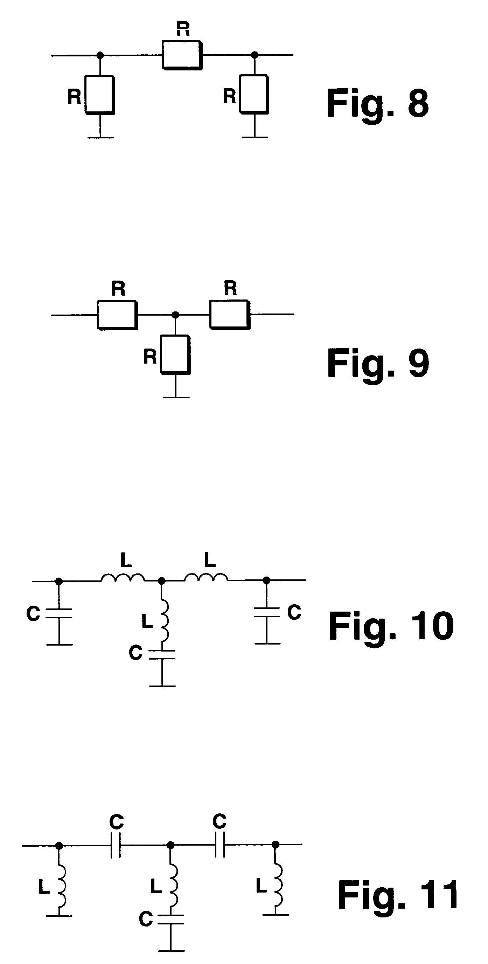

Die Figur 8 zeigt ein Dämpfungsglied 21, 31 in n-Form bestehend aus drei Widerständen R. Figur 9 zeigt ein Dämpfungsglied 21, 31 in T-Form bestehend aus drei Widerständen R.

Die Figur 10 zeigt ein passives Filterelement, bestehend aus Induktivitäten L und Kapazitäten C, mit Tiefpasseigenschaften.

Die Figur 11 zeigt ein passives Filterelement, bestehend aus Induktivitäten L und Kapazitäten C, mit Hochpasseigenschaften.

## Patentansprüche

1. Messeinrichtung (7) eines HF-Plasmasystems (100) mit einer Auskoppeleinrichtung (8) zur Auskopplung eines oder mehrerer mit einem HF-Signal in Beziehung stehenden Signale und wenigstens einer Filteranordnung, der ein solches Signal zugeführt ist, **dadurch gekennzeichnet, dass** die Filteranordnung als Bandpassfilteranordnung (14,15) ausgebildet ist und ein erstes und ein zweites Filterelement (22, 32, 25, 35) umfasst, zwischen denen ein Entkoppelglied (24, 34) angeordnet ist.

2. Messeinrichtung nach Anspruch 1, **dadurch gekennzeichnet, dass** das erste Filterelement (22, 32) als Tiefpassfilter und das zweite Filterelement (25, 35) als Hochpassfilter ausgebildet ist.

3. Messeinrichtung nach einem der vorhergehenden Ansprüche, **dadurch gekennzeichnet, dass** beide Filterelemente (22, 32, 25, 35) passive Filter sind.

4. Messeinrichtung nach einem der vorhergehenden Ansprüche, **dadurch gekennzeichnet, dass** vor dem ersten Filterelement (22, 32) ein Dämpfungsglied (21, 31) angeordnet ist.

5. Messeinrichtung nach einem der vorhergehenden Ansprüche, **dadurch gekennzeichnet, dass** das Entkoppelglied (24, 34) einen Verstärker aufweist ist.

6. Messeinrichtung nach einem der vorhergehenden Ansprüche, **dadurch gekennzeichnet, dass** nach dem Entkoppelglied (24, 34) ein Widerstand (26, 36) in Reihe geschaltet ist, der dem Systemwiderstand des zweiten Filterelements (25, 35) entspricht.

7. Messeinrichtung nach einem der vorhergehenden Ansprüche, **dadurch gekennzeichnet, dass** dem zweiten Filterelement (25, 35) ein zweites Entkoppelglied (28, 38) nachgeordnet ist.

8. Messeinrichtung nach einem der vorhergehenden Ansprüche, **dadurch gekennzeichnet, dass** ein Detektorglied (29, 39) vorgesehen ist, das der Bandpassfilteranordnung (14, 15) nachgeschaltet ist

9. Messeinrichtung nach einem der vorhergehenden Ansprüche, **dadurch gekennzeichnet, dass** für ein die Vorwärtsleistung und für ein die reflektierte Leistung beschreibendes Signal jeweils eine Bandpassfilteranordnung (14, 15), besonders bevorzugt jeweils einer Bandpassfilteranordnung (14, 15) mit jeweils einem vorgeschalteten Dämpfungsglied (21, 31), besonders bevorzugt mit jeweils einem nachgeschalteten Detektorglied (29, 35), vorgesehen ist.

10. Messeinrichtung nach einem der vorhergehenden Ansprüche, **dadurch gekennzeichnet, dass** ein Differenzbilder (16) vorgesehen ist, der die Differenz (P_{L}) aus Vorwärtsleitung (Pₗ) und reflektierter Leistung (Pᵣ) ermittelt.

11. Messeinrichtung nach einem der vorhergehenden Ansprüche, **dadurch gekennzeichnet, dass** die Auskoppeleinrichtung (8) als Richtkoppler mit mindestens einer Koppelleitung (10, 11) ausgebildet ist, wobei der Wellenwiderstand der Koppelleitung (10, 11) auf den Wellenwiderstand der daran angeschlossenen Leitungen ausgelegt ist.

12. Messseinrichtung nach Anspruch 11, **dadurch gekennzeichnet, dass** der Richtkoppler eine Durchgangsleitung (9) und zwei Koppelleitungen (10, 11) aufweist.

13. Messeinrichtung nach Anspruch 11 oder 12, **dadurch gekennzeichnet, dass** die Koppelleitungen (10, 11) zumindest an einem Ende mit einem Abschlusswiderstand (12, 13) abgeschlossen sind, dessen Widerstandswert dem Wellenwiderstand der Koppelleitung (10, 11) entspricht.

14. HF-Plasmasystem (100) mit einem HF-Generator (5), der eine HF-Leistung an eine Plasmalast (3) liefert, **gekennzeichnet durch** eine Messeinrichtung (7) nach einem der vorhergehenden Ansprüche.
